# EUROPEAN PATENT APPLICATION

(11) **EP 4 135 027 A1**
(43) Date of publication of application: **15.02.2023**
(21) Application number: 21306112.0
(22) Date of filing: 11.08.2021
(51) Int. Cl.: H01L 23/488, H01L 21/60, H05K 3/34, H01G 2/06, H01G 4/30, H01L 23/498

(54) **SURFACE-MOUNT COMPONENTS, METHODS OF MANUFACTURE THEREOF, AND MOUNTING METHODS EMPLOYING THE COMPONENTS**

(71) Applicant: Murata Manufacturing Co., Ltd., Nagaokakyo-shi, Kyoto 617-8555 (JP)
(72) Inventor: GABORIEAU, Sophie, 14210 STE HONORINE DU FAY (FR); YON, Dominique, 14750 SAINT AUBIN SUR MER (FR); POMMIER, Mickael, 14000 CAEN (FR)
(74) Representative: Cabinet Beau de Loménie

(57) **Abstract**

A surface-mount electronic component (20) comprises a substrate (2), a contact pad (8) on a first surface (2a) of the substrate (2), and a solder-stop frame (6) surrounding the contact pad (8). The solder-stop frame (6) delimits a solder-reception space (7) designed to receive solder material in contact with an accessible portion of the contact pad (8). During mounting of the surface-mount electronic component (20) on a mounting board (40), the contact pad of the surface-mount electronic component (20) becomes bonded to a landing pad (42) on the mounting board (40) using solder in the solder-reception space (7), whereby there is reduced tilt of the mounted component. The surface-mount component may be pre-bumped, that is, provided with a flat bonding bump in the solder-reception space (7). Methods of manufacture of the surface-mount components, and mounting methods using the surface-mount components are also described.

## Description

### Field of the Invention

The present invention relates to the field of surface mount technology and, more particularly, to improved surface-mount components, methods of their manufacture and mounting methods employing such components.

### Technical Background

Surface mount technology is widely used for mounting electronic components on mounting boards. Typically, a contact pad of a surface-mount component is soldered to a landing pad or conductive trace on the mounting board by forming a bump made of solder paste on the landing pad/trace, placing the surface-mount component so that its contact pad is positioned on the solder paste bump, then performing a reflow process.

A known problem that may arise during surface mounting of electronic components is that, after mounting, the surface-mount component is tilted rather than parallel to the mounting surface. This problem is exacerbated in the case of very small surface-mount components, for instance components in packages of 0201 type according to the JEDEC standardization, whose width and length dimensions are 0.6mm x 0.3 mm (0.02x0.01 inches), e.g., a 0201 discrete capacitor component.

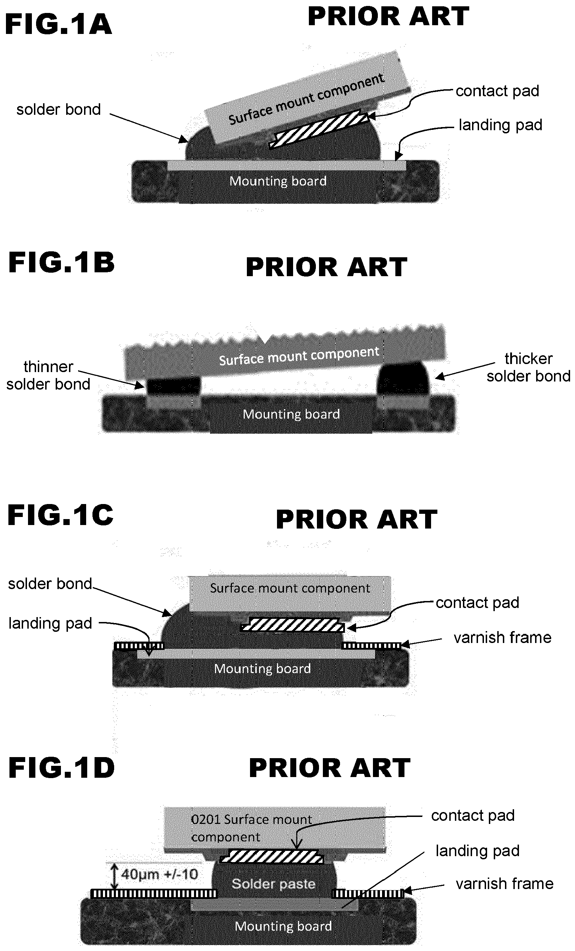

In the case where a very small surface-mount component is placed on a solder paste bump, during reflow the surface-mount component may begin to slide down one side of the bump and, after reflow, the surface mounted component is tilted: see the example illustrated in Fig.1A. In another example, a surface-mount component may have a plurality of contact pads which are bonded to corresponding landing pads/conductive traces on the mounting board and, unless all of the bonds have the same height/thickness dimensions, the mounted component may be tilted: see the example illustrated in Fig.1B. In particular, this problem may affect interposers which tend to have a plurality of contact pads that require bonding to landing pads on a mounting board. Tilt can derive from a lack of uniformity in the solder paste bumps that are deposited on the mounting board's landing pads/traces, or excess volume of the deposited solder paste. Typically, such lack of uniformity, or excess volume, of the bumps of solder paste may result from characteristics of a screen-printing process that is used to deposit the solder paste on the mounting-board-side landing pads/conductive traces.

Various problems may arise in the case where surface mounted components are tilted. For instance, the solder may come into contact undesirably with parts of the surface-mount component that are on the side or rear of the component (see Fig.1A), impairing the electrical properties of the mounted component or, even, causing a short-circuit. As another example, in the case of surface mounted broadband capacitors, a group of several such components may be mounted on a mounting board at an extremely small pitch, i.e., very close to one another. In such a case, tilt of the mounted capacitors can lead to undesirable electrical properties, such as undesirable insertion loss characteristics. Another problem caused by tilting of mounted surface-mount components relates to optical inspection processes that are often used during quality control of the finished circuit board. Such inspection processes often involve directing a beam of light towards the circuit board's mounting surface so that light reflected from mounted components can be detected by a sensor. However, in the case where the components mounted on the board are tilted, the reflected light may be displaced away from the expected direction and may fail to be captured by the sensor.

A number of solutions have been proposed to avoid tilting of surface mounted components. One approach consists in pre-forming flat (planarized) bonding bumps on the contact pads of the surface-mount component. Another approach consists in providing a varnish frame around each landing pad on the mounting board, so that the varnish frame can support a surface-mount component that is positioned to face the landing pad on the mounting board and the varnish frame can act, to some extent, like a solder mask or dam, restricting flow of the solder. However, even using such approaches, the solder bond that is formed may make undesired electrical contact with unintended regions of the surface-mount component, such as the side of the component, see the example illustrated in Fig.1C. This can cause undesired leakage current and degradation of electrical performances, even, short-circuits. To avoid such problems, generally it is necessary to restrict the thickness of deposited solder paste as illustrated in Fig.1D. However, effective control of the deposited thickness may be difficult to achieve.

The present invention has been made in the light of the above problems.

### Summary of the Invention

The present invention provides a surface-mount electronic component comprising:
a substrate;
a contact pad on a first surface of the substrate; and
a solder-stop frame surrounding the contact pad, defining the periphery of an accessible portion of the contact pad, and delimiting a solder-reception space to receive solder material in contact with the accessible portion of the contact pad.

In the surface-mount electronic component according to the invention, a solder-stop frame is provided on the surface-mount component itself. The solder-stop frame restricts outward spread of solder away from the contact pad during mounting, reducing or eliminating tilt. Also, the solder-stop frame provides increased clearance between the solder and portions of the surface-mount component that would be sensitive to leakage or short-circuits, increasing the process margin during assembly.

In certain embodiments of surface-mount electronic component according to the invention, the solder-stop frame may be part of a continuous layer of solder-stop material extending over the first surface of the substrate. Such a layer of solder-stop material may overlie passivation on the first surface of the substrate. In many components the passivation is relatively thin, so the layer of solder-stop material helps make the component more robust and protects the thin passivation on the die. In pre-bumped components (described below), the layer of solder-stop material on the first surface of the substrate simplifies the manufacturing process by providing a reliable height reference for a planarization process.

In certain embodiments of surface-mount electronic component according to the invention, the solder-stop frame is made of a polyimide. Polyimides have good chemical resistance and excellent thermal stability making them well-suited as solder-stop materials. Also, polyimides are easy to process at wafer-level and processing techniques are well-known to semiconductor manufacturers.

As tilt causes particular problems for surface-mounted broadband capacitors and interposers, the advantages of the present invention are particularly valuable in the case where the invention is applied to such components.

Certain embodiments of surface-mount electronic component according to the invention are "pre-bumped", that is, a flat bonding bump is provided on the contact pad and fills the solder-reception space. This embodiment provides a number of advantages, including enabling the component to be mounted by a variety of mounting methods (i.e., with or without flux, and (optionally) using additional solder). Other advantages of this configuration include:
- the end-user who will mount the component on a mounting board can easily mount small dies, i.e., without the need to use a specific stencil for depositing solder for small dies,
- the component (die) itself provides the appropriate amount of solder paste,
- it is possible for the end-user who will mount the component on a mounting board to use two different solder pastes on the same board as appropriate to the technology being employed, and
- these components are delivered with a flattened bump and therefore they can exhibit a low height.

The present invention further provides a method of fabricating the above-mentioned surface-mount electronic component, as defined in appended claim 7.

The present invention further provides a method of surface-mounting, on a mounting board, a surface-mount electronic component described above, as defined in appended claims 13 and 14.

### Brief Description of the Drawings

Further features and advantages of the present invention will become apparent from the following description of certain embodiments thereof, given by way of illustration only, not limitation, with reference to the accompanying drawings in which:
FIG. 1 illustrates problems that may arise in surface mounting components on a mounting board, in which:
FIG.1A illustrates a first example of a tilted surface-mounted component,
FIG.1B illustrates a second example of a tilted surface-mounted component,
FIG.1C illustrates an example of a short-circuit problem that may arise in a case where a varnish frame is provided on a mounting board, and
FIG.1D illustrates a restriction on solder thickness in a case where a varnish frame is provided on a mounting board;
FIG. 2 represents a simplified illustration of a surface-mount component according to a first embodiment of the invention, in which:
FIG.2A is a diagram representing a cross-section through the component, and
FIG.2B is a top plan view;
FIG. 3 represents a simplified illustration of a variant of the surface-mount component according to the first embodiment of the invention, in which:
FIG.3A is a diagram representing a cross-section through the component, and
FIG.3B is a top plan view;
FIG. 4 illustrates a first mounting method according to an embodiment of the invention, wherein a component according to Figs.2A and 2B is mounted on a mounting board, in which:
FIG.4A illustrates the component and board before bonding, and
FIG.4B illustrates the component mounted on the board;
FIG. 5 is a simplified illustration representing a cross-section through a surface-mount component according to a second embodiment of the invention;
FIG. 6 illustrates a mounting method according to an embodiment of the invention, wherein a component according to Fig.5 is mounted on a mounting board, in which:
FIG.6A illustrates the component and board before bonding using flux, and
FIG.6B illustrates the component mounted on the board;
FIG. 7 illustrates another mounting method according to an embodiment of the invention, wherein a component according to Fig.5 is mounted on a mounting board, in which:
FIG.7A illustrates the component and board before bonding using additional solder paste,
FIG.7B illustrates the component mounted on the board in a target orientation, and
FIG.7C illustrates the component mounted on the board in an orientation that departs from the target orientation;
FIG.8 illustrates, in cross-section, a component according to a third embodiment of the invention, mounted on a mounting board;
FIG.9 is a flow diagram illustrating steps in a method according to an embodiment of the invention for manufacturing a component according to the first embodiment and a component according to the second embodiment.
FIGs.10A-10D illustrate schematically a component according to the first embodiment at various stages during manufacture according to a method according to the first steps of Fig.9;
FIGs.11A and 11B illustrate schematically a component according to the second embodiment at various stages during manufacture according to a method according to Fig.9; and
FIG.12 illustrates surface layers in another example of a surface-mount component according to the second embodiment of the invention.

### Detailed Description of Example Embodiments

Embodiments of the present invention provide surface-mount components, methods of manufacture the components, and mounting methods employing the components.

Surface-mount components according to the invention incorporate a solder-stop frame on the die, and this solder-stop frame delimits the periphery of an accessible portion of the contact pad and defines a solder-reception space. During mounting of the component on a mounting board, the solder-stop frame acts as a kind of solder-mask or dam restricting the movement of solder paste that makes contact with the accessible portion of the contact pad. In certain embodiments of the invention the surface-mount component is "pre-bumped", that is, a solder bump is formed on the accessible portion of the contact pad delimited by the solder-stop frame.

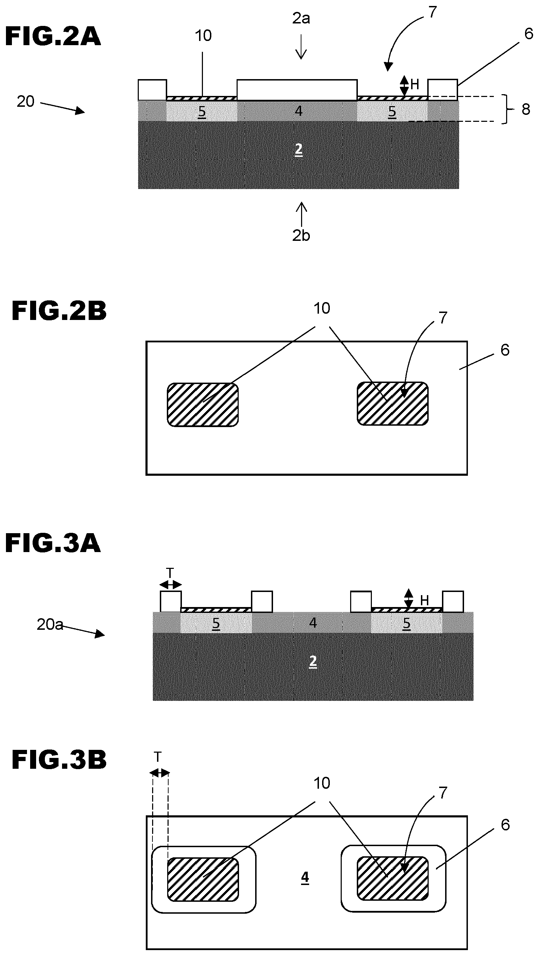

The structure of a first embodiment of surface-mount component according to the invention is illustrated in a simplified manner in Figs.2A and 2B, wherein Fig.2A illustrates the component in cross-section, and Fig.2B illustrates the component in top plan view.

In the example illustrated in Figs.2A and 2B, a surface-mount component 20 according to the first embodiment of the invention has two contacts 5 on a substrate 2. Each contact 5 is provided in a respective aperture in a passivation layer 4. The present invention is not particularly limited having regard to the respective materials used to form the substrate 2, the passivation layer 4 and the contacts 5. Typically, the substrate 2 is a semiconductor substrate, for example a silicon substrate, a SoI (silicon on insulator substrate), etc., but other materials may be used, for instance aluminium nitride (AIN), or other ceramics materials. Typically, the passivation layer 4 is made of a material providing mechanical protection, a moisture diffusion barrier and exhibiting good coverage properties as well as good electrical insulating properties, for example, silicon nitride. A typical range of values for the thickness of the passivation layer 4 is 0.5 to 1.5 µm, with a typical value being 1.5 µm.

Typically, the contacts 5 are made of an electrically conductive material, or a stack of electrically conductive materials, for instance aluminium, copper, aluminium alloys, etc. Aluminium, or alloys in which Al is a main component (e.g., with small quantities of Si and/or Cu), are preferred to Cu pads in view of the pollution problems associated with use of Cu. A typical value for the thickness of such Al contacts is 2-3µm.

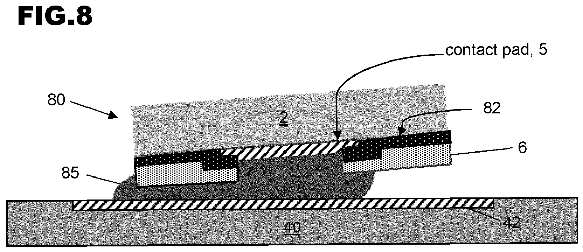

In a similar way, the present invention is not particularly limited having regard to the configuration (shape, presence or absence of some overlap, etc.) of the passivation layer 4 and the contact(s) 5 and, for example, the ends of a contact 5 may be overlain by portions of passivation layer material (as illustrated in Fig.8).

Furthermore, surface-mount components according to the invention are not limited in regard to the number of contacts 5: that is, besides the case of two contacts 5 illustrated in Figs.2A and 2B, other cases involve a single contact 5, or three or more contacts 5 being present.

In the example illustrated in Figs.2A and 2B, an Under Bump Metallization layer (UBM) 10 is provided on each contact 5 so as to allow alloying between the contact 5 and solder material which will be used to bond the surface-mount component 20 to a mounting board. Such an Under Bump Metallization layer (UBM) layer 10 may also serve to create a barrier to diffusion of materials from the solder paste into the underlying substrate. Below this layer will be referred to interchangeably as an adhesion layer or as a barrier layer.

The present invention is not particularly limited having regard to the material used to form the Under Bump Metallization layer (UBM) layer 10 and, indeed, the invention does not rely on the presence of an Under Bump Metallization layer (UBM). It may be considered that the contact pad 8 is formed by the combination of the contact 5 and the Under Bump Metallization layer (UBM) 10 (when the latter is present), or by the contact 5 (when no Under Bump Metallization layer (UBM) 10 is provided). Typically, an Under Bump Metallization layer (UBM) (if present) may be made, for example, NiAu, TiWAu or TiAu etc. (Ti or TiW being the adhesion layer and also a gold barrier diffusion layer). NiAu deposited via electroless process is preferred because it is a batch process (lower cost).

In the surface-mount component 20 according to the first embodiment of the invention, a layer of solder-stop material is provided over the entire surface of the substrate 2, with the exception of regions where contact pads are provided. Thus, the solder-stop material provides frames 6 of solder-stop material around the periphery of each contact pad, defining a solder-reception space 7 above each contact pad and delimiting the portion of the contact pad that is accessible for contact with solder.

The height H of the solder-reception space 7 is defined by the distance between the outer surface of the solder-stop material layer 6 and the outer surface of the contact pad (that is, the outer surface of the Under Bump Metallization layer (UBM) 10 (if present) or of the contact 5 (if no Under Bump Metallization layer (UBM) is present)). In preferred embodiments of the invention, the dimensions of the solder-reception space 7 are set taking into account the volume of solder paste that will be used in bonding the surface-mount component to the mounting board. Thus, as an example, in the case of a contact having dimensions of 100µm by 150µm the height H of the solder-reception space typically is set at 15µm.

In the example illustrated in Figs.2A and 2B the solder-stop material 6 is provided in a continuous layer covering the die and only leaving exposed the regions where contact pads are provided. However, other configurations may be used which involve solder-stop frames surrounding the desired contact pad(s). Thus, in a variant, the solder-stop material may be provided, not as a continuous layer, but rather as discrete frame-shaped portions of solder-stop material each surrounding a respective contact pad. Such a variant is illustrated in Figs.3A and 3B. In such variants, the thickness T of the boundary wall defining the frame is preferably set greater than 40 µm.

Various different materials may be used as the solder-stop material 6, notably materials that have good chemical resistance (to avoid inward diffusion of solder material, and to avoid leaching of solder-stop material into the solder) and good thermal stability (so as to retain integrity during solder reflow). Examples of suitable materials include: polyimide, benzocyclobutene (BCB), polybenzoxazole (PBO), epoxy-based resin, etc. It may be advantageous to use a polyimide to make the solder-stop frames used in the present invention because polyimides have good chemical resistance, excellent thermal stability (up to 400°C), as well as excellent dielectric properties, low coefficient of thermal expansion and good mechanical toughness. Also, in the semiconductor industry processes for deposition and patterning of polyimides are well-developed. The selection of the best material for a given application will depend on its thermal resistance, mechanical properties, chemical resistance and dielectric properties.

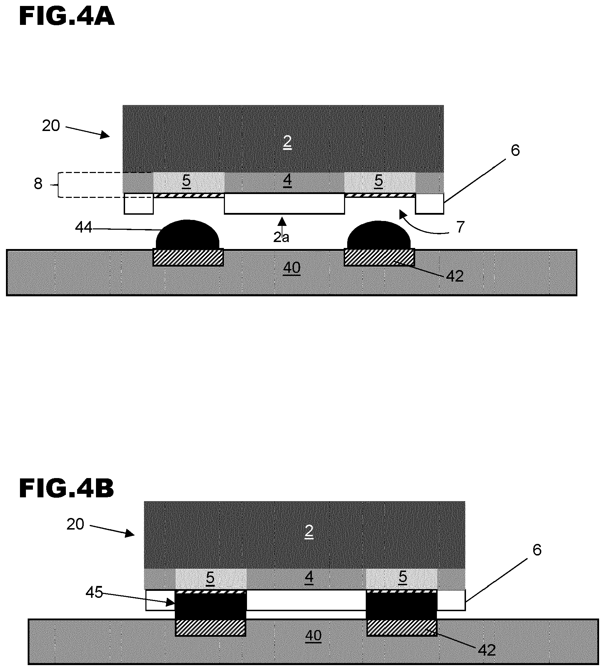

A first method of mounting a surface-mount component on a mounting board, in accordance with an embodiment of the invention, will now be described with reference to Figs.4A and 4B. In the example illustrated by Figs.4A and 4B, the surface-mount component is a component 20 according to the first embodiment of the invention.

As illustrated in Fig.4A, according to this first method beads 44 of solder paste are provided on landing pads 42 of a mounting board 40. Any convenient process may be used to deposit the beads 44 of solder paste on the landing pads 42, for instance screen-printing. Various known materials may be used as the solder paste, for instance, an AuSn alloy having the eutectic composition. The surface-mount component 20 is oriented so that the surface 2a where the contact pads are located faces the mounting surface of a mounting board 40. More particularly, the contact pads of the surface-mount component 20 are aligned with the respective landing pads 42 on the mounting board 40. The distance separating the surface-mount component 20 and the mounting board 40 is reduced so that the beads 44 of solder paste enter, and fill, the solder-reception spaces 7 defined by the solder-stop frames 6 on the surface-mount component 20. A reflow process is performed so to form a solid solder bond 45 between each of the contact pads and the corresponding landing pad 42 of the mounting board 40 as illustrated in Fig.4B.

It has been found that, by providing the solder-stop frames 6 on the surface-mount component 20, around the contact pads, there is reduced tilt of the surface-mount component after it has been bonded to the mounting board 40. Further, the likelihood of solder paste making undesired contact with portions at the sides or rear of the surface-mount component is reduced.

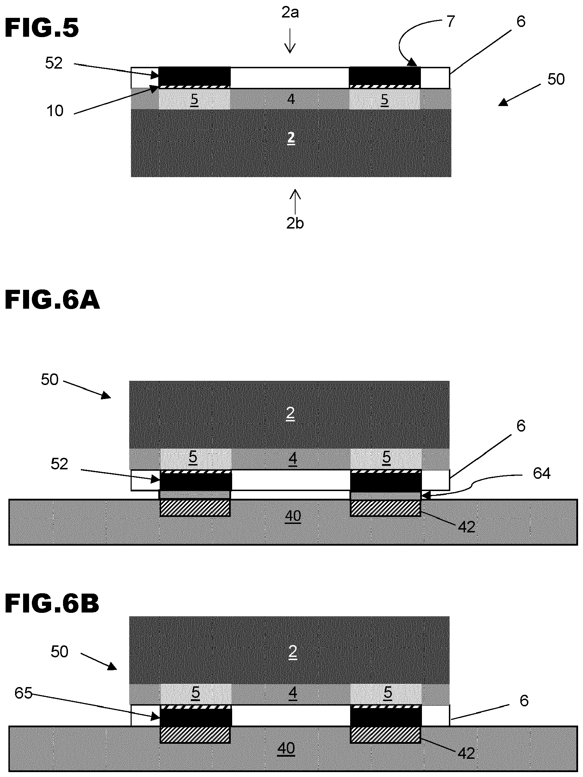

The structure of a second embodiment of surface-mount component 50 according to the invention is illustrated in a simplified manner in Fig.5 (which illustrates the component in cross-section). Certain elements that can be the same as those described above in relation to the first embodiment are indicated using the same reference numerals and the description thereof is omitted. Only elements that differ from the first embodiment are described in detail here.

In the example illustrated in Fig.5 two contacts 5 are represented and the solder-stop frames 6 are defined by a continuous layer of solder-stop material. However, it is to be understood that the number of contacts 5 can be different from two (as discussed above in connection with the first embodiment), and the solder-stop frames 6 can take different forms, notably, they may be constituted by discrete frames as in the variant illustrated in Figs.3A and 3B.

The surface-mount component 50 according to the second embodiment of the invention is "pre-bumped", that is, a solder bump 52 is formed on the accessible portion of the contact pad delimited by the solder-stop frame 6. In the illustrated example the outer surface of each bonding bump 52 is substantially coplanar with the outer surface of the solder-stop layer 6. In other words, the bonding bumps 52 are planarized.

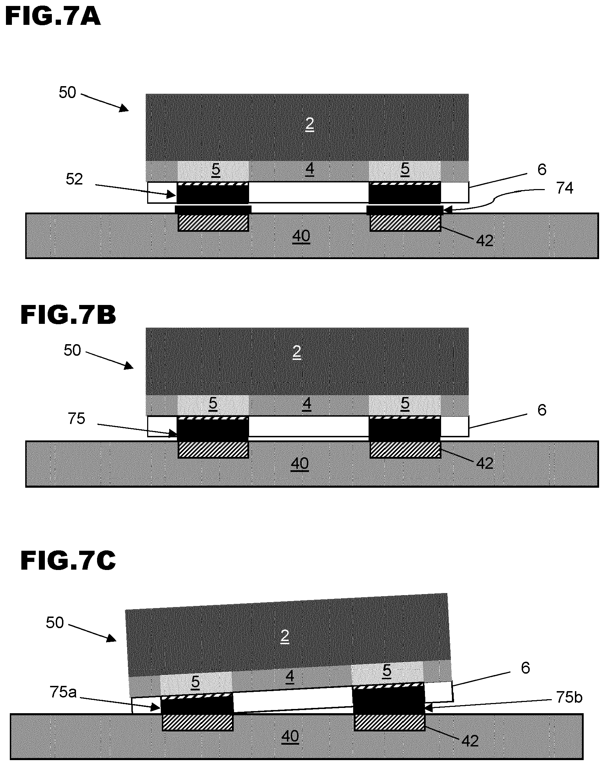

Two methods of mounting a surface-mount component on a mounting board, in accordance with embodiments of the invention, will now be described with reference to Figs.6A and 6B, and with reference to Figs.7A-7C, respectively. In the examples illustrated in Figs.6A and 6B and in Figs.7A-7C, the surface-mount component is a component 50 according to the second embodiment of the invention. The method illustrated by Figs.6A and 6B relates to a mounting process that makes use of flux. The method illustrated by Figs.7A-7C relates to a mounting process that makes use of additional solder paste.

According to the method illustrated in Figs.6A and 6B, each of the solder bumps 52 of the surface-mount component 50 is aligned with a respective corresponding landing pad 42 on the mounting board 40, with a volume of flux 64 interposed between the facing component-side solder bump 52 and mounting-board-side landing pad 42. A reflow process is performed so to soften the solder 52 and allow the formation of a solid solder bond 65 between each of the contact pads and the corresponding landing pad 42 of the mounting board 40 as illustrated in Fig.6B. During the reflow process, the flux 64 cleans undesired oxides and the like from the pads being bonded, enabling a high-quality solder bond 65 to be formed.

So, as for the method described above in relation with Figs.4A and 4B, the method according to Figs.6A and 6B results in reduced tilt of the surface-mount component 50 after it has been bonded to the mounting board 40, and reduced likelihood of the solder bond 65 making undesired contact with portions at the sides or rear of the surface-mount component 50. Moreover, the mounting method according to Figs.6A and 6B results in the mounted component being particularly close to the surface of the mounting board 40.

There may be circumstances where it is desired to provide (additional) solder paste on the mounting-board side landing pads 42 even though the surface-mount component 50 is pre-bumped. This may be the case, for example, if the manufacturer wants to use the same screen-printing stencil for depositing solder to mount other components, besides component 50, on the same board. According to the method illustrated in Figs.7A to 7C, beads 74 of solder paste are provided on landing pads 42 of a mounting board 40. The pre-bumped surface-mount component 50 is oriented so that the outer surface of the bonding bumps 52 faces the mounting surface of the mounting board 40. More particularly, the outer surface of the component-side bonding bumps 52 are aligned with the respective landing pads 42 on the mounting board 40. The distance separating the surface-mount component 50 and the mounting board 40 is reduced so that the beads 74 of solder paste make contact with the component-side bonding bumps 52. A reflow process is performed so as to merge the beads 74 of solder paste on the mounting board with the component-side bonding bumps 52 and form a solid solder bond 75 between each of the contact pads 5 (5,10) of the surface-mount component 50 and the corresponding landing pad 42 of the mounting board 40 as illustrated in Fig.7B.

Generally, as for the methods described above in relation with Figs.4A and 4B, and Figs.6A and 6B, the method discussed above with reference to Figs.7A and 7B also results in reduced tilt of the surface-mount component 50 after it has been bonded to the mounting board 40, and reduced likelihood of the solder bond 75 making undesired contact with portions at the sides or rear of the surface-mount component 50. It may be the case that, due to inconsistency in the volume of solder paste deposited as the different beads 74 on the landing pads 42 of the mounting board 40, a first solder bond 75a joining the surface-mount component 50 and the mounting board 40 is shorter than a second solder bond 75b. However, even in this case the degree of tilt is generally lower than in prior proposals because the volume of solder paste in the beads 74 is lower than would be the case if these solder beads were the sole source of solder contributing to the bonds 75 and, therefore, the prospective difference in volume between the solder beads 74 is small.

Incidentally, although the mounting methods described above with reference to figs.4A and 4B, Figs.6A and 6B, and Figs.7A -7C illustrate examples in which a surface-mount component is bonded to a mounting board via two solder bonds, and tilting is reduced, the invention procures a reduction in tilt even in the case where the surface-mount component has a single contact pad. In this regard, Fig.8 illustrates an example of a surface-mount component 80 according to the present invention, having a single contact pad 5 and a solder-stop frame 6. In the illustrated example a passivation layer 82 overlaps the ends of the contact pad 5. Fig.8 illustrates the component 80 after mounting on a mounting board 40 using a mounting method according to Figs.7A-7B.

It has been found that the component-side solder-stop frame may result in reduced tilt of the components according to embodiments of the invention after they have been surface-mounted. Also, the solder-stop frame provides increased clearance between the solder and portions of the surface-mount component that would be sensitive to leakage or short-circuits. In other words, as can be seen from Fig.8, in the event that the solder bond 85 includes a portion where the solder has spread outward away from the contact pad and landing pad, this spread portion is likely to contact the solder-stop frame 6, rather than the side of the surface-mounted component 80, as can be seen towards the left-hand side of Fig.8. This contrasts with the prior art case illustrated in Fig.1C.

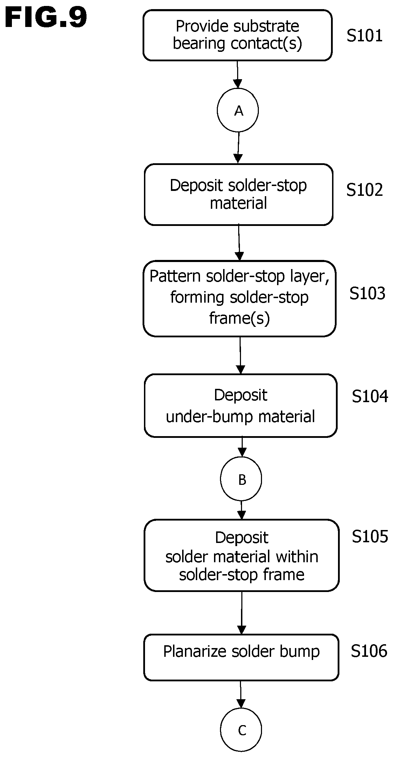

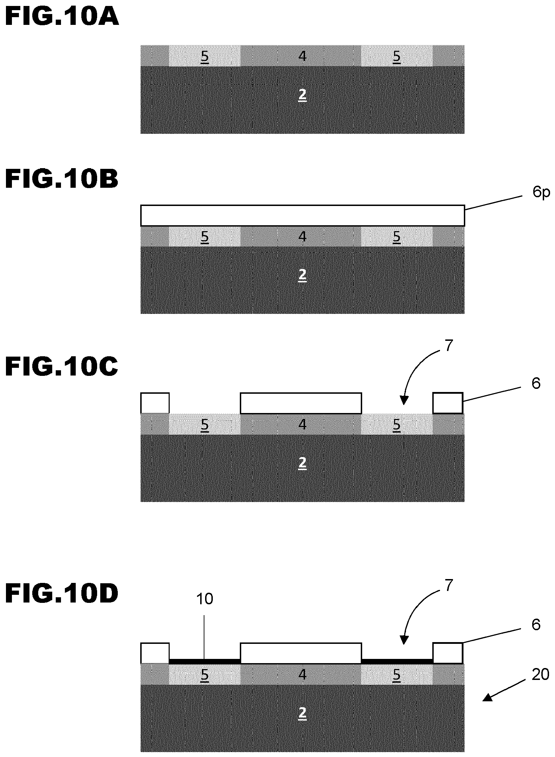

Methods of manufacturing surface-mount components according to the above-described first and second embodiments of the invention will now be described with reference to the flow chart of Fig.9. The first steps in Fig.9 serve to manufacture a surface-mount component 20 according to the first embodiment of the invention, and performance of the complete set of steps of Fig.10 enables a surface-mount component 50 according to the second embodiment of the invention to be manufactured.

An example of a method of manufacturing a surface-mount component 20 according to the first embodiment of the invention will now be described with reference to Fig.9 and the diagrams in Figs.10A-10D (which illustrate the component 20 at various stages in its manufacture).

The initial stage (S101) in the method according to Fig.9 consists in providing a substrate having contacts that will require bonding to a mounting substrate (see Fig.10A). The operations involved in preparing the substrate with its contacts (the die) varies depending on the nature of the surface-mount component and the fabrication of the die may well be performed by a party different from the party which implements the method according to Fig.9. in view of the fact that the detailed steps involved in fabrication of the die are not relevant to the explanation of the invention they shall not be discussed further here.

In certain implementations of the method of Fig.9, the next step is the deposition of solder-stop material (S102). Typically, this involves deposition of a continuous layer 6p of solder-stop material over the entire surface (or a selected region) of the die (see Fig.10B). The skilled person will readily appreciate that various different processes may be used to deposit the solder-stop layer 6p depending on the nature of the chosen solder-stop material. For example, in a case where the solder-stop material is polyimide, the solder-stop layer 6p may be deposited by spin coating, lamination, etc.

The layer 6p of solder-stop material is then patterned to former solder-stop frames 6 around the contact pad locations (see step S103 of Fig.9 and the illustration in Fig.10C). Fig.10C illustrates a structure corresponding to the first embodiment of the invention that is illustrated in Figs.2A and 2B but the patterning may produce other frame structures, e.g., the frame structure of the variant illustrated in Figs.3A and 3B. As explained above, the solder-stop frames 6 define solder-reception spaces 7 to receive solder that will bond the electrode pads to landing pads on a mounting board. Known processes (e.g., photolithographic and wet or dry etching processes) may be used to pattern the solder-stop material layer 6p and so these processes are not discussed in detail here.

An Under Bump Metallization (UBM) layer 10 may be deposited on the contacts 5 through the openings defined by the solder-stop frames 6 in a step S103 subsequent to the patterning of the solder-stop layer. However, the invention is not particularly limited in regard to the timing of the steps of depositing the solder-stop material and forming the Under Bump Metallization (UBM) layer 10. Thus, in a variant, the Under Bump Metallization (UBM) layer 10 may be deposited on the contacts 5 before the solder-stop material is deposited on the die (i.e., at stage A indicated in Fig.9).

The skilled person will readily appreciate that various different processes may be used to deposit (and, when appropriate, to pattern) the material forming the Under Bump Metallization (UBM) layer 10 depending on the nature of the chosen material. For example, in a case where the Under Bump Metallization (UBM) layer is made of TiWAu, the TiWAu may be deposited by TiW sputtering followed by Au electroplating (although the invention is not limited to the use of that process). In certain preferred embodiments, an Under Bump Metallization (UBM) layer 10 is made of NiAu deposited by an electroless process.

By the stage indicated by B in Fig.9, the structure illustrated in Fig.10D has been completed, which corresponds to a surface-mount component 20 according to the first embodiment of the invention.

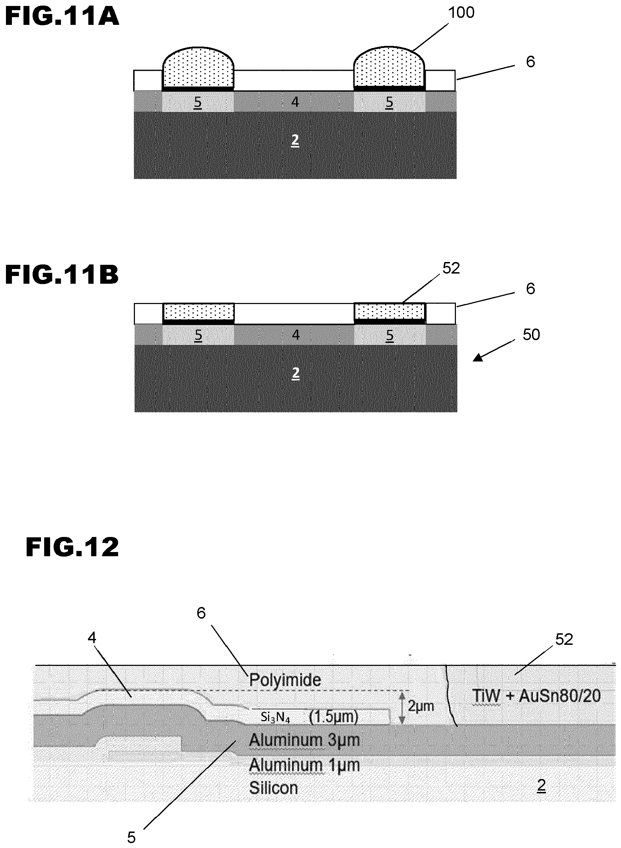

A method of manufacturing a surface-mount component 50 according to the second embodiment of the invention will now be described with reference to Fig.9 and the diagrams in Figs.11A and 11B (which illustrate the component 50 at various of the later stages in its manufacture). The initial stages of this method, i.e., the steps up to stage B in Fig.9, may be the same as those described above in regard to manufacture of a component according to the first embodiment.

Starting from the structure illustrated in Fig.10D, the method of manufacturing a component according to the second embodiment of the invention continues (S105) by depositing solder material 100 in the solder-reception space 7 defined by the solder-stop frame 6 (see Fig.11A). Solder material 100 is deposited in a volume sufficient to fill the solder-reception space 7, and to protrude above the surface of the solder-stop frame 6. The skilled person will readily appreciate that various different processes may be used to deposit the solder material 100 depending on the nature of the chosen solder material. For example, in a case where the solder material is a SAC alloy, the solder material 100 may be deposited by screen printing, ball dropping, etc.

Next, S106, the solder material in the solder-reception space 7 is planarized to produce a flat bump 52 of desired height (see Fig.11B). In general, the bump height is set based on the global product assembly specifications and requirements. The planarization of the solder material may be performed by any convenient process, for example, by planarization grinding, by chemical mechanical polishing, etc. The planarization process is facilitated in embodiments of the invention in which the solder-stop frames 6 form part of a continuous layer of solder-stop material, because the surface of the solder-stop layer then provides a reliable height reference for use during the planarization process. This issue may be better understood from a consideration of Fig.12.

Fig.12 is an enlarged view of a more realistic representation of the top layers of a real-world surface-mount component fabricated in accordance with the second embodiment of the invention. Compared to the simplified representations shown in the other figures, Fig.12 provides a more realistic representation of the general shapes of layers that are provided in the electronic component. Thus, it can be seen that there may be a stepped shape (or other topographical features) in the region where passivation 4 overlaps with the edge of a contact 5. If the bonding bump 52 were to be formed on the electrode pad without any solder-stop frame being present in the component, then during the planarization process it would be difficult to find a reliable positional reference based on the surface of the die, in view of the variation (in the vertical direction in the drawing) of the positions of the top surfaces of the aluminium and passivation layers (which, as illustrated, can vary by an amount of the order of 2µm). In contrast, the solder-stop material layer 6 provides a reliable positional reference that can be used during planarization. Incidentally, it will be understood that in the process of forming the flat bonding bump 52 the thickness of the solder-stop layer 6 may be reduced as well as reducing the height of the bonding bump.

### Additional Variants

Although the present invention has been described above with reference to certain specific embodiments, it will be understood that the invention is not limited by the particularities of the specific embodiments. Numerous variations, modifications and developments may be made in the above-described embodiments within the scope of the appended claims.

For example, although the figures show surface-mount components in which every contact pad is provided with a solder-stop frame, it will be understood that, if desired solder-stop frames may be provided only for a subset of the contact pads, or even only for one contact pad.

## Claims

1. A surface-mount electronic component (20) comprising:
a substrate (2);
a contact pad (8) on a first surface (2a) of the substrate (2); and
a solder-stop frame (6) surrounding the contact pad (8), defining the periphery of an accessible portion of the contact pad (8), and delimiting a solder-reception space (7) to receive solder material in contact with the accessible portion of the contact pad (8).

2. The electronic component (20) according to claim 1, wherein the solder-stop frame (6) is comprised in a continuous layer of solder-stop material extending over the first surface (2a) of the substrate.

3. The electronic component (20) according to claim 2, wherein said layer of solder-stop material overlies passivation (4) on the first surface (2a) of the substrate.

4. The electronic component (50) according to any one of claims 1-3, wherein the solder-stop frame (6) is made of a polyimide.

5. The electronic component according to any one of claims 1-4, wherein the surface-mount electronic component is a device selected in the group consisting of: a capacitor, a broadband capacitor, and an interposer.

6. The electronic component (50) according to any one of claims 1-5, further comprising a flat bonding bump (52) provided on the contact pad (8) and filling the solder-reception space (7).

7. A method of manufacturing a surface-mount electronic component (20), comprising:
providing a substrate (2) having, on a first surface (2a) thereof, a contact pad (8); and
forming a solder-stop frame (6) surrounding the contact pad (8), said solder-stop frame (6) defining the periphery of an accessible portion of the contact pad (8) and delimiting a solder-reception space (7) to receive solder material in contact with the accessible portion of the contact pad (8).

8. The manufacturing method according to claim 7, wherein the forming of the solder-stop frame (6) comprises forming a continuous layer of solder-stop material extending over the first surface (2a) of the substrate (2).

9. The manufacturing method according to claim 8, wherein the forming of the continuous layer of solder-stop material comprises forming said layer of solder-stop material overlying passivation (4) on the first surface (2a) of the substrate.

10. The manufacturing method according to any one of claims 7-9, wherein the solder-stop frame (6) is made of a polyimide.

11. The manufacturing method according to any one of claims 7-10, wherein the surface-mount electronic component is a device selected in the group consisting of: a capacitor, a broadband capacitor, and an interposer.

12. The manufacturing method according to any one of claims 7-11, further comprising:
filling the solder-reception space (7) with solder material; and
planarizing the solder material in the solder-reception space (7) to form a flat bonding bump (52) on the contact pad (8).

13. A method of surface-mounting, on a mounting board, a surface-mount electronic component according to any one of claims 1-5, the mounting method comprising:
providing a bead (44) of solder paste on a landing pad (42) of the mounting board (40);
positioning the surface-mount electronic component (20) facing the mounting board (40) with the solder-reception space (7) of the surface-mount electronic component (50) facing the bead (44) of solder paste on the landing pad (42) of the mounting board (40);
bringing the surface-mount component (20) and the mounting board together to introduce solder of the solder bead (44) into the solder-reception space (7); and
performing a reflow process to bond the contact pad (8) of the surface-mount electronic component (20) to the landing pad (42) of the mounting board (40) using the material of the solder bead (44).

14. A method of surface-mounting, on a mounting board, a surface-mount electronic component (50) according to claim 6, the mounting method comprising:
positioning the surface-mount electronic component (50) facing the mounting board (40) with the flat bonding bump (52) of the surface-mount electronic component (50) facing a landing pad (42) of the mounting board (40); and
performing a reflow process to bond the contact pad (8) of the surface-mount electronic component (50) to the landing pad (42) of the mounting board (40) using the material of the flat bonding bump (52).
